Europäisches
Patentamt

European
Patent Office

Office européen
des brevets

(11)  **EP 2 019 447 B1**

(12)  **EUROPEAN PATENT SPECIFICATION**

(45) Date of publication and mention
of the grant of the patent:
**15.05.2019  Bulletin 2019/20**

(51) Int Cl.:
*H01Q 1/24* *(2006.01)*    *H01Q 1/52* *(2006.01)*
*H01Q 15/00* *(2006.01)*

(21) Application number: **08013464.6**

(22) Date of filing: **25.07.2008**

(54) **Electromagnetic screen**

Elektromagnetischer Bildschirm

Écran électromagnétique

(84) Designated Contracting States:
**DE FR GB**

(30) Priority:  **25.07.2007  RU 2007128677**

(43) Date of publication of application:
**28.01.2009  Bulletin 2009/05**

(73) Proprietor: **Samsung Electronics Co., Ltd.**
**Suwon-si, Gyeonggi-do, 443-742 (KR)**

(72) Inventors:
 • **Kazantsev, Yury Nikolaevich**
  **Suwon-si**
  **Gyeonggi-do (KR)**
 • **Apletalin, Vladimir Nikolaevich**
  **Suwon-si**
  **Gyeonggi-do (KR)**
 • **Kaloshin, Vadim Anatolievich**
  **Suwon-si**
  **Gyeonggi-do (KR)**

(74) Representative: **Grünecker Patent- und**
 **Rechtsanwälte**
 **PartG mbB**
 **Leopoldstraße 4**
 **80802 München (DE)**

(56) References cited:
 **WO-A-02/49146    US-B1- 6 225 939**
 **US-B1- 6 483 480**

• **ROMULO F JIMENEZ BROAS ET AL: "A
 High-Impedance Ground Plane Applied to a
 Cellphone Handset Geometry" IEEE
 TRANSACTIONS ON MICROWAVE THEORY AND
 TECHNIQUES, IEEE SERVICE CENTER,
 PISCATAWAY, NJ, US, vol. 49, no. 7, 1 July 2001
 (2001-07-01), XP011038350 ISSN: 0018-9480**
 • **JON ANDERS AAS: "PLANE-WAVE REFLECTION
 PROPERTIES OF TWO ARTIFICIALLY HARD
 SURFACES" IEEE TRANSACTIONS ON
 ANTENNAS AND PROPAGATION, IEEE SERVICE
 CENTER, PISCATAWAY, NJ, US, vol. 39, no. 5, 1
 May 1991 (1991-05-01), pages 651-656,
 XP000206416 ISSN: 0018-926X**

**Description**

**BACKGROUND OF THE INVENTION**

**FIELD OF THE INVENTION**

The present invention relates to a device for shielding electromagnetic radiation.

**DISCUSSION OF THE BACKGROUND**

The problem of designing screens for electromagnetic radiation has a long history. Since the development of radio engineering and electronics, the question of suppression of electromagnetic communication between separate circuits and units has been dealt with. Of equal concern is the reduction of the influence of electromagnetic radiation on surrounding wildlife and humans.

Conventional screens include metallic structures (metal sheets, a film, a grid etc.) and radio absorbing materials, as disclosed by O. S. Ostrovsky, *et al.*: "Filters and absorbers of electromagnetic waves," ФІП ФИП PSE (Ukraine), 2003, Vol. 1, No 2, pp. 161-173. Significant progress in the area of radio absorbing materials has been achieved for last 30 years in connection with works on a direction which usually designated as "Stealth". Screens including a composite magnetic-dielectric in a microwave range have been developed thin enough (thickness about units of millimeters), broadband (more an octave) radio absorbing coverings which can be applied to electromagnetic shielding successfully. However, it was known that in order for screens of both types to effectively shield electromagnetic radiation, their cross-section sizes should be equal to many wave-lengths. Over the last decade, and in particular in connection with development of mobile communication, the need for screens that are small in comparison to length of a wave for shielding radiation has grown. Simple reduction of the cross-sectional sizes of metallic and radio-absorbing screens does not give an essential positive effect because electromagnetic waves may easily flow around such screens. For example, the miniscreen "Wave Buster" (South Korea) made in the form of a 15 mm diameter tablet that is 4 mm thick on the basis of layered radio-absorbing material decreases the radiation of the aerial of all on 10-20 %, i.e. less than on 1 dB. And as disclosed by Jiunn-Nan Hwang, et al.: "Reduction of the Peak SAR in the Human Head with Metamaterials," IEEE Trans. on Antennas and Propag ., 54, Dec. 2006, the plate of a radio-absorber (ferrite) of the greater area (45x45x6 mm) decreases the radiation on 6 dB for frequency of 0.9 GHz.

Radical change of the situation with the shielding of small aerials should be connected to publications of D. Sievenpiper and others (see U.S. Patent No. 6,483,480, D. Sievenpiper, et al.; Sievenpiper D. et al.: "High-Impedance Electromagnetic Surfaces with a Forbidden Frequency Band," IEEE Trans. on Microwave Theory and Tech., vol. 47, Nov. 1999, pp. 2059-2074; Jimenez Broas, et al.: "High-Impedance Ground Plane Applied to Cellphone Handset Geometry," IEEE Trans. on Microwave Theory and Tech., v. 49, Jul. 2001, pp. 1262-1265) in which surfaces with a high surface impedance are considered. Such surfaces differently name artificial magnetic conductors (AMC) as at falling an electromagnetic wave on this surface the tangential magnetic field has a node instead of an antinode, as on a surface of an electric conductor. In particular, it is shown that behind such surfaces, even with a limited cross-section size, the area of a deep electromagnetic shadow is formed, i.e. the surface is the screen of electromagnetic radiation. Also, it has been shown that application of a resonance high impedance surface as a ground plane of aerials increases its directivity. As disclosed by Jimenez Broas R. F. *et al.*, for the model of the mobile phone antenna located on an AMC with sizes 25x50 mm, the "forward - back" ratio for a 2.5 GHz signal was about 10 dB.

Attempts to apply a metamaterial on the basis of double open rings to shielding have shown that the structure from 10 layers in volume 34x34x15 mm has an attenuation of 3 dB for 1.8 GHz, as disclosed by Jiunn-Nan Hwang, *et al.*

U.S. Patent No. 6,483,480 discloses a tunable impedance surface. The one includes two two-periodic lattices from the metal squares parallel to a metallic ground on distance small in comparison with the length of a wave. The distance between lattices also is small in comparison with length of a wave. Each element of the first lattice nearest to a metal substrate is connected to a metal ground. This lattice is motionless. The second lattice, which is mobile, can be shifted to the first lattice so that the distance between lattices remains constant. The impedance in a plane of a mobile lattice depends on a frequency of electromagnetic radiation and geometry of lattices. The surface impedance is maximal near to resonant frequency of the given system. The resonance of system is the resonance of a large number of the connected elementary resonators. Each elementary resonator is formed by capacity between two elements of the mobile and motionless lattices and also inductance of the circuit including a site of a metal substrate and 2 next conductors connecting elements of the motionless lattice with a metal substrate.

The tunable impedance surface disclosed in U.S. Patent No. 6,483,480 may have a non-uniform surface impedance due to the limited size. Elementary resonators at edges of an impedance surface are connected to a smaller number of the next resonators than elementary resonators in the center of an impedance surface. Thus, resonant frequencies of elementary resonators and corresponding local impedances depend on location of these resonators. An undesirable result of the non-uniform impedance is the "washing out" of the effect of shielding, (i.e. its reduction on working frequencies of the screen). Another problem with the tunable impedance surface disclosed in U.S. Patent No. 6,483,480 is the complexity of the design in which a large number of shorting connections of all elements of a motionless lattice are connected with a conducting substrate.

US 6225939 B1 discloses a screen according to the preamble of claim 1.

## SUMMARY OF THE INVENTION

The invention provides an electromagnetic screen according to claim 1.

The present invention provides a device that may have a greater and more homogeneous surface impedance for small screens that shield electromagnetic radiation in a working range of frequencies. The tangential component of an electric field on a surface of the device is non-zero and a tangential component of a magnetic field and hence and a surface current are close to zero. Thus, a screen according to an exemplary embodiment of the present invention is an artificial magnetic conductor (AMC). The electromagnetic wave radiated by an electric dipole or a monopole forms the area of a deep electromagnetic shadow behind the AMC. In particular, placing an electromagnetic screen, according to an exemplary embodiment of the present invention, between the aerial of mobile phone and a user's head may shield the user's head from electromagnetic radiation.

The present invention also provides a screen that may shield electromagnetic radiation of the aerial behind it and form the area of a shadow, (i.e. the pattern of the aerial has a minimum).

Additional features of the invention will be set forth in the description which follows, and in part will be apparent from the description, or may be learned by practice of the invention.

The specified technical result is reached because in the electromagnetic screen with the big surface impedance containing flat metallic reflector and two capacitor type parallel lattices located above the last shifted from each other on a part of the period and at least one of fringes of lattices has electric connection with an edge of reflector.

It is to be understood that both the foregoing general description and the following detailed description are exemplary and explanatory and are intended to provide further explanation of the invention as claimed.

## BRIEF DESCRIPTION OF THE DRAWINGS

The accompanying drawings, which are included to provide a further understanding of the invention and are incorporated in and constitute a part of this specification, illustrate embodiments of the invention, and together with the description serve to explain the principles of the invention.

FIG. 1A and FIG. 1B show electromagnetic screens according to exemplary embodiments of the present invention.
FIG. 2A and FIG. 2B show the arrangement of face surfaces of the electromagnetic screens according to exemplary embodiments of the present invention.
FIG. 3A and FIG. 3B show electromagnetic screens according to exemplary embodiments of the present invention.
FIG. 4 is a graph showing resonant frequencies.
FIG. 5 shows a system used to measure resonant frequencies.
FIG. 6A and FIG. 6B show a frequency and angular dependence of the coefficient of transmission, respectively.

## DETAILED DESCRIPTION OF THE ILLUSTRATED EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers and regions may be exaggerated for clarity. Like reference numerals in the drawings denote like elements.

It will be understood that when an element or layer is referred to as being "on" or "connected to" another element or layer, it can be directly on or directly connected to the other element or layer, or intervening elements or layers may be present. In contrast, when an element is referred to as being "directly on" or "directly connected to" another element or layer, there are no intervening elements or layers present.

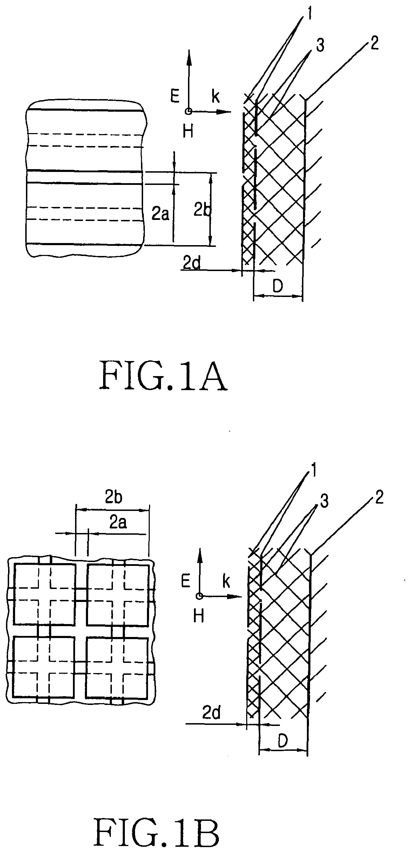

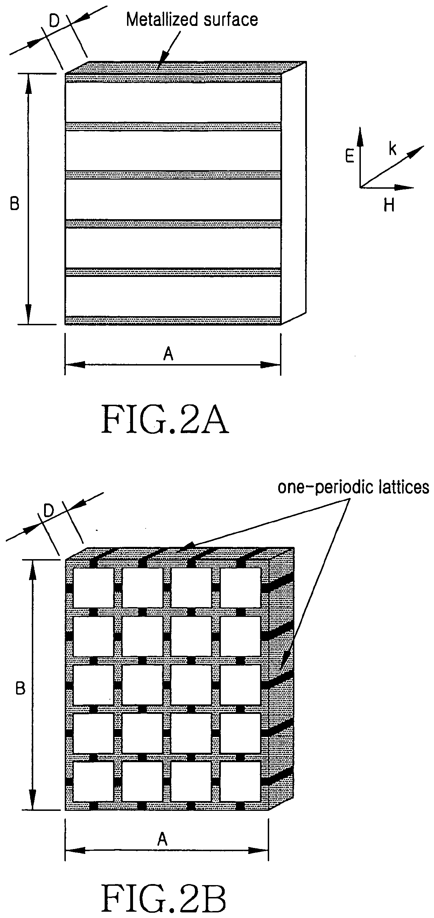

Referring to FIG. 1A and FIG. 1B, electromagnetic screens according to exemplary embodiments of the present invention include lattices 1 of a capacitor type, a reflector 2, and dielectric layers 3. Although FIG. 1A and FIG. 1B both show metal lattices, FIG. 1A shows strip lattices and FIG. 1B shows square lattices. FIG. 2A and FIG. 2B show the arrangement of face surfaces of the electromagnetic screens according to exemplary embodiments of the present invention with continuous metallization and metallization as one-periodic lattice and two-periodic lattice, respectively. This lattice is made from thin conductors with a small period in comparison with the cross-sectional sizes A and B of the electromagnetic screen.

Characteristics of an AMC with large cross-sectional sizes

As noted above, electromagnetic screens according to exemplary embodiments of the present invention are artificial magnetic conductors (AMC) due to their electromagnetic properties. The basic difference of an AMC from an electric conductor consists in the following: at falling an electromagnetic wave on surface AMC on this surface antinode of tangential component of electric field and node of a tangential component of a magnetic field are formed. Otherwise, the reflection coefficient of tangential component of an electric field is equal +1 for AMC instead of -1 as in the case of an electric conductor.

Patterns of AMC on the basis of two closely located capacitor lattices are shown in FIG. 1A and FIG. 1B. One-periodic lattices in FIG. 1A are made from thin metallic strips and two-periodic lattices in FIG. 1B are made from metallic squares. The sizes of these structures satisfy the conditions:

$$d \ll a \ll b \ll \lambda \qquad (1)$$

Where $\lambda$ is wave- length.

The basic characteristics of an AMC are considered in detail in J.N. Kazantsev, et al.: "Artificial magnetic conductors on the basis of lattices of capacitor type," 52, Feb. 2007. Here, we remark only some necessary results for AMC with the sizes there is more than length of a wave.

The capacitor lattices and a metal plane form the flat resonator the coefficient of reflection from which on resonant frequency is equal +1 (on a cross-component of an electric field). Resonant frequency $f_p$ at normal incidence a wave on AMC is estimated under the following formula:

$$f_p = \frac{c}{\pi\sqrt{2}\sqrt{\dfrac{\varepsilon D b(b-2a)}{d}}} \qquad (2)$$

Where $c$ is the speed of light and $\varepsilon$ is the dielectric permeability of a material between lattices. The phase of coefficient of reflection (on a cross component of an electric field) varies in an interval $\pm\pi/2$ in a strip of frequencies $2\Delta f$:

$$2\Delta f = f_p / Q \qquad (3)$$

Where the coefficient Q is estimated under the following formula:

$$Q = \sqrt{\frac{\varepsilon b(b-2a)}{2dD}} \qquad (4)$$

The module of coefficient of reflection from an AMC is less than 1 due to radiation and losses in metal and dielectric. The radiation is the reason of reduction of area AMC where the resonance eventually disappears. Thus, influences of two orthogonal sizes AMC on a resonance are essentially various. So reduction of the size perpendicular to the direction of an electric field poorly influences resonant frequency down to the sizes comparable to distance between lattices and a metal plane. On the contrary, reduction of other size orthogonal to the first leads to an increase in resonant frequency already at the sizes smaller than length of a wave.

Characteristics of an AMC with small cross-section sizes

For designing small screens on the basis of AMC, the undesirable effect of radiation should be removed at its edges. For this purpose, in the case of the one-periodic (one-polarizing) structure in FIG. 1A, there may be continuous metallization of two face surfaces perpendicular to a vector of an electric field (see FIG. 2A). Partial elimination of undesirable effect of radiation may take place even if the metallization is on one face surface. In the case of the two-periodic (two-polarizing) structure in FIG. 1B, metallization of all face surfaces is carried out in the form of a lattice from thin conductors (see FIG. 2B). In the latter case, metallization of end faces perpendicular to a vector $\vec{E}$ of an electric field behaves as continuous and metallization of two staying end faces should not influence appreciably a field in resonant volume between pair lattices and a metal plane as conductors of lattices here are perpendicular to a vector $\vec{E}$. As a result, a screen according to an exemplary embodiment of the present invention formed of such AMC represents the flat resonator formed in pair of lattices, a metal plane, and metallized end faces.

An electromagnetic wave falling on a screen (mini-screen) according to an exemplary embodiment on resonant frequency it is formed antinode by a tangential component of an electric field and node - magnetic on its surface. The band of frequencies of the mini-screen is determined by resonant frequency and Q- factor of the resonator.

In comparison with a conventional screen, the technical result - uniformity of an impedance on surface of an AMC of the limited size - may be reached by that a screen according to an exemplary embodiment represents the uniform resonator with the certain resonant frequency and a homogeneous field of its mode in a plane of capacitor lattices. It is natural that periodic oscillations of a field along lattices are not taking in attention at definition of the impedance.

Resonant frequency of the electromagnetic screen

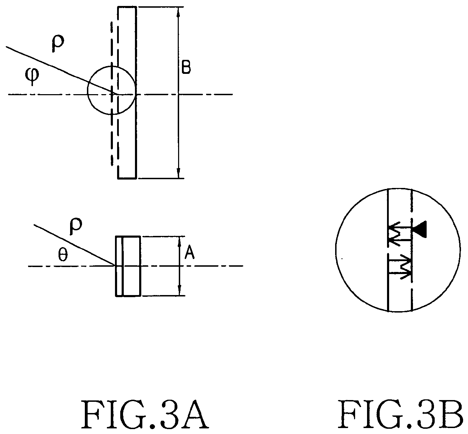

A screen according to an exemplary embodiment of the present invention represents the resonator in which it is easy to allocate capacity and inductance as the electric field is concentrated between lattices and magnetic - in volume between pair lattices, a metal plane, and metallized end faces. Therefore, the capacity of the resonator is formed by elements of lattices, and inductance is determined by volume of an internal cavity of the resonator. The further calculations will be carried out for the one-periodic structure represented in FIG. 1A and FIG. 2A. Results of these calculations are right for the two-periodic structures represented in FIG. 1B and FIG. 2B too as the sizes of slots (2a) are small in comparison with the period (2b) of the lattices. The capacity of the resonator C is generated by consecutive connection of 2n flat condensers where "n" is the number of metal strips of an external lattice (see FIG. 3):

$$C \approx \frac{\varepsilon A(b-2a)}{16\pi dn} \tag{5}$$

The internal cavity of the resonator has the form of a tube of rectangular section BxD. Inductance $L$ of such a tube under condition of $A>>D$ is estimated by the following formula:

$$L = \frac{4\pi BD}{A} \tag{6}$$

Resonant frequency $f_p$ can be calculated under known formula

$$f_p = \frac{c}{2\pi\sqrt{LC}} \tag{7}$$

Having substituted in (7) expressions (5) and (6) we shall obtain:

$$f_p = \frac{c}{\pi\sqrt{\dfrac{\varepsilon(b-2a)BD}{dn}}} \tag{8}$$

At the big number of the periods of a lattice it is possible to count that $B/n \approx 2b$ and formula (8) transforms in the formula (2). Here, in the case of two-periodic structure, formula (8) should be slightly specified:

$$f_{\mathrm{p}} = \frac{c}{\pi\sqrt{\dfrac{\varepsilon(b-4a)BD}{dn}}}$$

$$(9)$$

Resonant frequency was measured for a series of samples with identical structure of lattices (2b=4MM, 2a=0.3 mm, 2d=0.1 mm) and identical thickness D but different in the cross-section sizes A and B. The sizes of samples are shown below in Table 1. Dielectric permittivity of the material between lattices 1 and between the lattice 1 and a metal plane 2 is equal 2.25 and 2.55, respectively.

Table 1

| Sample N | A mm | B mm | D mm | 2n | fm GHZ measured | f c GHz calculated |
|---|---|---|---|---|---|---|
| 1 | 11 | 24 | 3.40 | 10 | 2.84 | 2.70 |
| 2 | 20 | 25 | 3.45 | 10 | 2.72 | 2.63 |
| 3 | 20 | 35 | 3.45 | 16 | 2.7 | 2.81 |
| 4 | 20 | 18 | 3.45 | 6 | 2.52 | 2.4 |
| 5 | 6.8 | 24 | 3.45 | 10 | 3.02 | 2.68 |
| 6 | 4.8 | 24 | 3.45 | 10 | 3.53 | 2.68 |

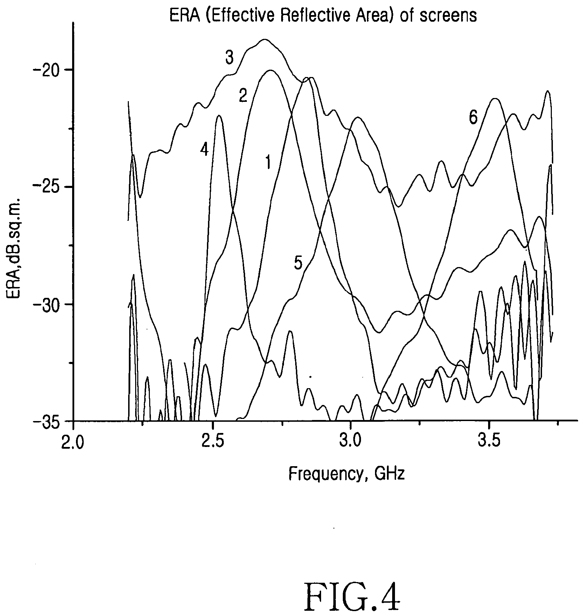

Resonant frequency was determined on a maximum of frequency dependence of radar cross section (RCS) of a sample in space. RCS measurements were carried out in compact range polygon IRE RAS, per Yu. N. Kazantsev, et al.: "Electromagnetic Wave Backscattering from Structures with Anisotropic Conductivity," Proc. IX International Conf. on Spin-Electronics, Nov. 2000, Moscow (Firsanovka), UNC-1 MPEI (TU)), with the use the quasioptical reflectometer, per V. N. Apletalin, et al.: "Centimeter and millimeter waves reflectometers on a basis hollow metal-dielectric waveguides," ,Aug. 2005, pp. 44-46, complete with the vector analyzer. The dependences in dB relative M in power 2 are presented in FIG. 4. The reference numerals 1-6 on the curves of FIG. 4 correspond to numbers of samples N in Table 1. From the presented curves follows:
Resonant frequency poorly depends on the cross-sectional sizes of a sample at condition A/D> 2.

The width of a resonant curve poorly depends on the size A but quickly grows with increase in the size B.

Values of resonant frequencies measured and calculated using the formula (8) are shown in Table 1. As one would expect under condition of A>>D, good correlation takes place between experimental and calculated results. At A comparable with D, the measured value of resonant frequencies is essentially more than calculated one.

Estimation of effect of shielding:

An explanation of the effect of shielding of electromagnetic radiation of AMC structures is a little electric current on a surface of the AMC near to resonant frequency, as discussed in O. S. Ostrovsky, et al. and U.S. Patent No. 6,483,480. The experimental estimation of effect of shielding was carried out in practically important ranges near to frequencies of 1.8 GHz and 2.5 GHz. The samples of mini-screens were made on the basis of one-periodic and two-periodic lattices. All lattices had the following parameters: 2b=6 mm, 2a=0.3 mm and 2d=0.1 mm. Permittivity of materials between lattice 1 and between the lattice 1 and a metallic plane 2 are $\varepsilon$ =2.25 (polythene) and $\varepsilon_1$ =2.55 (polystyrene), respectively.

Overall dimensions of samples and other characteristics are shown in Table 2. Resonant frequencies $f_p$ in the table are calculated under formulas (8) and (9). In samples 1-3, electric connection between lateral edges of lattices and an edge of a reflector is made by continuous metallization of two opposite face surfaces. In a sample 4, electric connection is made on all four face surfaces in the form of two-periodic lattice from thin conductors with 6 mm period.

Table 2

| Sample N | Type of lattices | A cm | B cm | D cm | fm GHZ measured | f c GHz calculated |
|---|---|---|---|---|---|---|
| 1 | One periodic | 2.0 | 4.5 | 0.427 | 1.75 | 1.69 |
| 2 | One periodic | 1.0 | 4.5 | 0.445 | 1.75 | 1.62 |

(continued)

| Sample N | Type of lattices | A cm | B cm | D cm | fm **GHZ measured** | f c GHz calculated |
|----------|-----------------|------|------|-------|---------------------|--------------------|
| 3 | One periodic | 2.0 | 3.3 | 0.377 | 1.91 | 1.72 |
| 4 | Two-periodic | 3.3 | 3.3 | 0.227 | 2.49 | 2.33 |

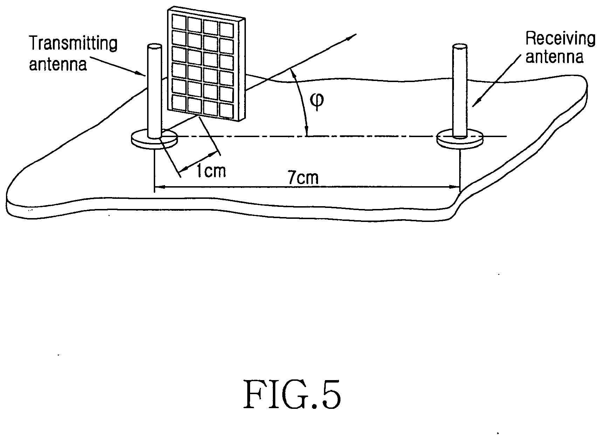

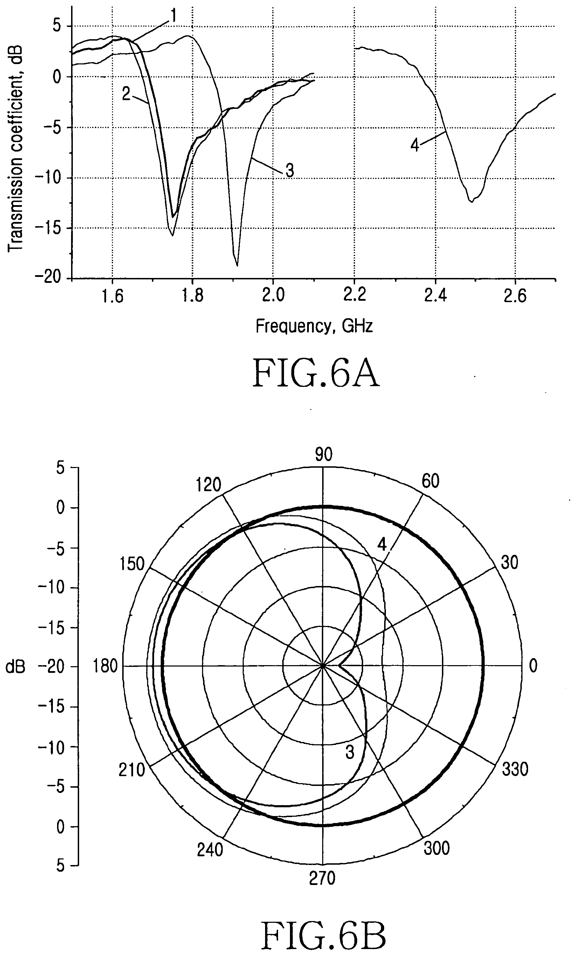

The measuring equipment is shown in FIG. 5. The level of shielding was determined by measurement of coefficient of transmission between two monopoles in length of 30 mm. The frequency dependence of the normalized coefficient of transmission is shown in FIG. 6A in case of $\varphi=0$. The angular dependence of coefficient of transmission on frequency fm for which this coefficient is minimal (is resulted in case of $\varphi=0$) is shown in FIG. 6B. The figures on the curves of FIG. 6A and FIG. 6B correspond to numbers of samples N in Table 2. Measurements have shown that frequencies of shielding fm depend and on the sizes of the structure of lattices and also thickness of a sample D and practically do not depend on the cross-sectional sizes A and B. In FIG. 6A and FIG. 6B, the effect of shielding more than 15 dB is observed.

Thus, an electromagnetic screen according to an exemplary embodiment of the present invention carries out the function of shielding of electromagnetic radiation at the cross-sectional sizes essentially smaller than length of a wave. For realization of effective shielding radiation of aerials such as an electric dipole or an electric monopole, the screen sets down on distance $(0.01 \div 0.1)$ length of a wave from a surface of the aerial. Thus, the surface of capacitor lattices is parallel to an axis of the aerial and faces the aerial.

An electromagnetic screen according to an exemplary embodiment of the present invention may decrease electromagnetic radiation of aerials more than on 15 dB in a direction of the maximal shielding at distances between it and the aerial essentially smaller than length of a wave.

It will be apparent to those skilled in the art that various modifications and variation can be made in the present invention without departing from the scope of the invention. Thus, it is intended that the present invention cover the modifications and variations of this invention provided they come within the scope of the appended claims.

**Claims**

1. An electromagnetic screen having a high surface impedance, the screen comprising:

   a flat metal reflector substrate (2); and
   two capacitor-type lattices located above the reflector substrate,
   wherein the capacitor-type lattices comprise:

   a first dielectric layer (3) on the reflector substrate (2);
   a first thin metal layer (1) on the first dielectric layer (3), the first thin metal layer (1) comprising a plurality of pieces that are spaced apart from each other by a period;
   a second dielectric layer (3) on the first thin metal layer (1);
   a second thin metal layer (1) being arranged in parallel with the first thin metal layer (1) and on the second dielectric layer (3), the second thin metal layer (1) comprising a plurality of pieces that are spaced apart from each other by the period, the pieces of the second thin metal layer being shifted from the pieces of the first thin metal layer on a share of the period in a direction parallel to the flat metal reflector substrate (2); and

   wherein the electromagnetic screen is an artificial magnetic conductor (AMC);
   **characterized in that**
   at least one of lateral edges of the lattices has an electric connection with an edge of the reflector substrate (2); and the electric connection comprises a first connector that connects a first edge of the first thin metal layer (1) to a first edge of the reflector substrate (2), the first connector being disposed on a first outermost surface of the first dielectric layer (3).

2. The electromagnetic screen of claim 1, wherein the electric connection comprises a continuous metal layer that is located on one or two opposite face surfaces of the screen.

3. The electromagnetic screen of claim 1, wherein the capacitor-type lattices form a two-period lattice and wherein the electric connection comprises a continuous metal layer that is located on all face surfaces of the screen.

4. The electromagnetic screen of claim 1, further comprising a second connector that connects a second edge of the first thin metal layer to a second edge of the reflector substrate, the second connector being disposed on a second outermost surface of the first dielectric layer (3), wherein the second outermost surface of the first dielectric layer (3) opposes the first outermost surface of the first dielectric layer (3).

5. The electromagnetic screen of claim 4, wherein the first connector and the second connector each comprise a metal layer.

6. The electromagnetic screen of claim 4, further comprising:

a third connector that connects a third edge of the first thin metal layer to a third edge of the reflector substrate (2), the third connector being disposed on a third outermost surface of the first dielectric layer (3); and
a fourth connector that connects a fourth edge of the first thin metal layer (1) to a fourth edge of the reflector substrate (2), the fourth connector being disposed on a fourth outermost surface of the first dielectric layer (3); wherein the third outermost surface of the first dielectric layer (3) opposes the fourth outermost surface of the first dielectric layer (3).

7. The electromagnetic screen of claim 6, wherein the first connector, the second connector, the third connector, and the fourth connector each comprise a metal layer.

8. The electromagnetic screen of claim 1, wherein each of the pieces of the first thin metal layer (1) and the second thin metal layer (1) comprise metallic strips that each extend across an entire width of the first dielectric layer (3).

9. The electromagnetic screen of claim 1, wherein each of the pieces of the first thin metal layer (1) and the second thin metal layer (1) comprise metallic squares that each has a width that is less than a width of the first dielectric layer (3).

10. The electromagnetic screen of claim 1, wherein a permittivity of the first dielectric layer (3) is greater than a permittivity of the second dielectric layer (3).

11. The electromagnetic screen of claim 1, wherein a thickness of the first dielectric layer (3) is greater than a thickness of the second dielectric layer (3).

12. The electromagnetic screen of claim 1, wherein:

the first dielectric layer (3) is directly on the reflector substrate (2);
the first thin metal layer (1) is directly on the first dielectric layer (3);
the second dielectric layer (3) is directly on the first thin metal layer (1);
the second thin metal layer (1) is directly on the second dielectric layer (3); and
the first connector is directly on the first outermost surface of the first dielectric layer (3).


**Patentansprüche**

1. Elektromagnetischer Bildschirm mit einer hohen Oberflächenimpedanz, wobei der Bildschirm ein flaches Metallreflektorsubstrat (2) und zwei Gitter vom Kondensator-Typ, die sich über dem Reflektorsubstrat befinden, umfasst, wobei die Gitter vom Kondensator-Typ umfassen:

eine erste dielektrische Schicht (3) auf dem Reflektorsubstrat (2);
eine ersten dünne Metallschicht (1) auf der ersten dielektrischen Schicht (3), wobei die erste dünne Metallschicht (1) eine Vielzahl an Teilen umfasst, die durch eine Periode voneinander beabstandet sind;
eine zweite dielektrische Schicht (3) auf der ersten dünnen Metallschicht (1);
eine zweite dünne Metallschicht (1), die parallel zu der ersten dünnen Metallschicht (1) und auf der zweiten dielektrischen Schicht (3) angeordnet ist, wobei die zweite dünne Metallschicht (1) eine Vielzahl an Teilen umfasst, die durch eine Periode voneinander beabstandet sind, wobei die Teile der zweiten dünnen Metallschicht von den Teilen der ersten dünnen Metallschicht um einen Teil der Periode in einer Richtung parallel zu dem flachen Metallreflektorsubstrat (2) verschoben sind; und

wobei der elektromagnetische Bildschirm ein künstlicher magnetischer Leiter (AMC: artificial magnetic conductor) ist;
**dadurch gekennzeichnet, dass**
mindestens eine der Seitenkanten der Gitter eine elektrische Verbindung mit einer Kante des Reflektorsubstrats (2) aufweist; und
die elektrische Verbindung einen ersten Verbinder umfasst, der eine erste Kante der ersten dünnen Metallschicht (1) mit einer ersten Kante des Reflektorsubstrats (2) verbindet, wobei der erste Verbinder auf einer ersten äußersten Oberfläche der ersten dielektrischen Schicht (3) angeordnet ist.

2. Elektromagnetischer Bildschirm nach Anspruch 1, wobei die elektrische Verbindung eine durchgehende Metallschicht umfasst, die sich auf einer oder zwei gegenüberliegenden Seitenflächen des Bildschirms befindet.

3. Elektromagnetischer Bildschirm nach Anspruch 1, wobei die Gitter vom Kondensator-Typ ein Zweiperiodengitter bilden und wobei die elektrische Verbindung eine durchgehende Metallschicht umfasst, die sich auf allen Seitenflächen des Bildschirms befindet.

4. Elektromagnetischer Bildschirm nach Anspruch 1, der des Weiteren einen zweiten Verbinder umfasst, der eine zweite Kante der ersten dünnen Metallschicht mit einer zweiten Kante des Reflektorsubstrats verbindet; wobei der zweite Verbinder auf einer zweiten äußersten Oberfläche der ersten dielektrischen Schicht (3) angeordnet ist, wobei die zweite äußerste Oberfläche der ersten dielektrischen Schicht (3) der ersten äußersten Oberfläche der ersten dielektrischen Schicht (3) gegenüberliegt.

5. Elektromagnetischer Bildschirm nach Anspruch 4, wobei der erste Verbinder und der zweite Verbinder jeweils eine Metallschicht umfassen.

6. Elektromagnetischer Bildschirm nach Anspruch 4, der des Weiteren umfasst:

   einen dritten Verbinder, der eine dritte Kante der ersten dünnen Metallschicht mit einer dritten Kante des Reflektorsubstrats (2) verbindet, wobei der dritte Verbinder auf einer dritten äußersten Oberfläche der ersten dielektrischen Schicht (3) angeordnet ist;
   einen vierten Verbinder, der eine vierte Kante der ersten dünnen Metallschicht (1) mit einer vierten Kante des Reflektorsubstrats (2) verbindet, wobei der vierte Verbinder auf einer vierten äußersten Oberfläche der ersten dielektrischen Schicht (3) angeordnet ist;
   wobei die dritte äußerste Oberfläche der ersten dielektrischen Schicht (3) der vierten äußersten Oberfläche der ersten dielektrischen Schicht (3) gegenüberliegt.

7. Elektromagnetischer Bildschirm nach Anspruch 6, wobei der erste Verbinder, der zweite Verbinder, der dritte Verbinder und der vierte Verbinder jeweils eine Metallschicht umfassen.

8. Elektromagnetischer Bildschirm nach Anspruch 1, wobei jedes der Teile der ersten dünnen Metallschicht (1) und der zweiten dünnen Metallschicht (1) metallische Streifen umfasst, die sich jeweils über eine gesamte Breite der ersten dielektrischen Schicht (3) erstrecken.

9. Elektromagnetischer Bildschirm nach Anspruch 1, wobei jedes der Teile der ersten dünnen Metallschicht (1) und der zweiten dünnen Metallschicht (1) metallische Quadrate umfasst, die jeweils eine Breite aufweisen, die kleiner als die Breite der ersten dielektrischen Schicht (3) ist.

10. Elektromagnetischer Bildschirm nach Anspruch 1, wobei eine Dielektrizitätskonstante der ersten dielektrischen Schicht (3) größer als eine Dielektrizitätskonstante der zweiten dielektrischen Schicht (3) ist.

11. Elektromagnetischer Bildschirm nach Anspruch 1, wobei eine Dicke der ersten dielektrischen Schicht (3) größer als eine Dicke der zweiten dielektrischen Schicht (3) ist

12. Elektromagnetischer Bildschirm nach Anspruch 1, wobei:

   die erste dielektrische Schicht (3) sich direkt auf dem Reflektorsubstrat (2) befindet;
   die erste dünne Metallschicht (1) sich direkt auf der ersten dielektrischen Schicht (3) befindet;

die zweite dielektrische Schicht (3) sich direkt auf der ersten dünnen Metallschicht (1) befindet;

die zweite dünne Metallschicht (1) sich direkt auf der zweiten dielektrischen Schicht (3) befindet; und

der erste Verbinder sich direkt auf der äußersten Oberfläche der ersten dielektrischen Schicht (3) befindet.

**Revendications**

1. Écran électromagnétique présentant une impédance de surface élevée, l'écran comprenant :

   un substrat réfléchissant métallique plat (2), et
   deux réseaux de type capacitif situés au-dessus du substrat réfléchissant,
   dans lequel les réseaux de type capacitif comprennent :

   une première couche diélectrique (3) sur le substrat réfléchissant (2),
   une première couche métallique mince (1) sur la première couche diélectrique (3), la première couche métallique mince (1) comprenant une pluralité d'éléments espacés l'un de l'autre d'une période,
   une seconde couche diélectrique (3) sur la première couche métallique mince (1),
   une seconde couche métallique mince (1) agencée en parallèle avec la première couche métallique mince (1) et sur la seconde couche diélectrique (3), la seconde couche métallique mince (1) comprenant une pluralité d'éléments qui sont espacés l'un de l'autre d'une période, les éléments de la seconde couche métallique mince étant décalés des éléments de la première couche métallique mince sur une part de la période dans une direction parallèle à celle du substrat réfléchissant métallique (2), et
   dans lequel l'écran électromagnétique représente un conducteur magnétique artificiel (AMC),

   **caractérisé en ce que**
   au moins l'un des bords latéraux des réseaux présente une connexion électrique avec un bord du substrat réfléchissant (2), et
   la connexion électrique comprend un premier connecteur qui relie un premier bord de la première couche métallique mince (1) à un premier bord du substrat réfléchissant (2), le premier connecteur étant disposé sur la première surface la plus externe de la première couche diélectrique (3).

2. Écran électromagnétique selon la revendication 1, la connexion électrique comprend une couche métallique continue qui est située sur une ou deux surfaces des faces opposées de l'écran.

3. Écran électromagnétique selon la revendication 1, dans lequel les réseaux de type capacitif forment un réseau bi périodique et dans lequel la connexion électrique comprend une couche métallique continue qui est située sur la totalité des surfaces des faces de l'écran.

4. Écran électromagnétique selon la revendication 1, comprenant en outre un deuxième connecteur qui relie un deuxième bord de la première couche métallique mince à un deuxième bord du substrat réfléchissant, le deuxième connecteur étant disposé sur la deuxième surface la plus externe de la première couche diélectrique (3), la deuxième surface la plus externe de la première couche diélectrique (3) étant opposée à la première surface la plus externe de la première couche diélectrique (3).

5. Écran électromagnétique selon la revendication 4, dans lequel le premier connecteur et le deuxième connecteur comprennent chacun une couche métallique.

6. Écran électromagnétique selon la revendication 4, comprenant en outre :

   un troisième connecteur qui relie un troisième bord de la première couche métallique mince à un troisième bord du substrat réfléchissant (2), le troisième connecteur étant disposé sur la troisième surface la plus externe de la première couche diélectrique (3), et
   un quatrième connecteur qui relie un quatrième bord de la première couche métallique mince (1) à un quatrième bord du substrat réfléchissant (2), le quatrième connecteur étant disposé sur la quatrième surface la plus externe de la première couche diélectrique (3),
   dans lequel la troisième surface la plus externe de la première couche diélectrique (3) est opposée à la quatrième surface la plus externe de la première couche diélectrique (3) .

**7.** Écran électromagnétique selon la revendication 6, dans lequel le premier connecteur, le deuxième connecteur, le troisième connecteur et le quatrième connecteur comprennent chacun une couche métallique.

**8.** Écran électromagnétique selon la revendication 1, dans lequel chacun des éléments de la première couche métallique mince (1) et de la seconde couche métallique mince (1) comprend des bandes métalliques qui s'étendent chacune de part et d'autre sur toute la largeur de la première couche diélectrique (3).

**9.** Écran électromagnétique selon la revendication 1, dans lequel chacun des éléments de la première couche métallique mince (1) et de la seconde couche métallique mince (1) comprend des carrés métalliques qui présentent chacun une largeur qui est inférieure à la largeur de la première couche diélectrique (3).

**10.** Écran électromagnétique selon la revendication 1, dans lequel la permittivité de la première couche diélectrique (3) est supérieure à la permittivité de la seconde couche diélectrique (3).

**11.** Écran électromagnétique selon la revendication 1, dans lequel l'épaisseur de la première couche diélectrique (3) est supérieure à l'épaisseur de la seconde couche diélectrique (3).

**12.** Écran électromagnétique selon la revendication 1, dans lequel :

la première couche diélectrique (3) se trouve directement sur le substrat réfléchissant (2),
la première couche métallique mince (1) se trouve directement sur la première couche diélectrique (3),
la seconde couche diélectrique (3) se trouve directement sur la première couche métallique mince (1),
la seconde couche métallique mince (1) se trouve directement sur la seconde couche diélectrique (3), et
le premier connecteur se trouve directement sur la première surface la plus externe de la première couche diélectrique (3).

FIG.1A

FIG.1B

FIG.2A

FIG.2B

FIG.3A          FIG.3B

FIG.4

FIG.5

FIG.6A

FIG.6B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6483480 B, D. Sievenpiper

- US 6225939 B1

### Non-patent literature cited in the description

- **JIUNN-NAN HWANG et al.** Reduction of the Peak SAR in the Human Head with Metamaterials. *IEEE Trans. on Antennas and Propag,* December 2006, vol. 54
- **SIEVENPIPER D. et al.** High-Impedance Electromagnetic Surfaces with a Forbidden Frequency Band. *IEEE Trans. on Microwave Theory and Tech.,* November 1999, vol. 47, 2059-2074
- **JIMENEZ BROAS et al.** High-Impedance Ground Plane Applied to Cellphone Handset Geometry. *IEEE Trans. on Microwave Theory and Tech.,* July 2001, vol. 49, 1262-1265
- **J.N. KAZANTSEV et al.** *Artificial magnetic conductors on the basis of lattices of capacitor type,* February 2007, vol. 52
- **YU. N. KAZANTSEV et al.** Electromagnetic Wave Backscattering from Structures with Anisotropic Conductivity. *Proc. IX International Conf. on Spin-Electronics,* November 2000
- **V. N. APLETALIN et al.** *Centimeter and millimeter waves reflectometers on a basis hollow metal-dielectric waveguides,* August 2005, 44-46